# EUROPÄISCHE PATENTANMELDUNG

(11) **EP 1 174 907 A2**
(43) Veröffentlichungstag der Anmeldung: **23.01.2002**
(21) Anmeldenummer: 01115215.4
(22) Anmeldetag: 22.06.2001
(51) Int. Cl.: H01L 21/00

(54) **Halbleitervorrichtung mit Temperaturregelung**

(30) Priorität: 14.07.2000 DE 10034262
(71) Anmelder: Infineon Technologies AG, 81669 München (DE)
(72) Erfinder: von der Ropp, Thomas, 82110 Germering (DE)
(74) Vertreter: Müller . Hoffmann & Partner Patentanwälte

(57) **Zusammenfassung**

Die Erfindung betrifft eine Halbleitervorrichtung, bei welcher eine integrierte Schaltung (2) Dummy-Arbeitszyklen ausführt, um Wärme zu erzeugen, wenn die Temperatur der Halbleitervorrichtung unter einen unteren Grenzwert abfällt.

## Beschreibung

Die vorliegende Erfindung betrifft eine Halbleitervorrichtung mit wenigstens einer in einem Halbleiterbaustein realisierten integrierten Schaltung, einer Strom- bzw. Spannungsversorgung, einer Temperaturerkennungseinrichtung, die eine Temperatur des Halbleiterbausteins festzustellen vermag, und einer mit der Temperaturerkennungseinrichtung verbundenen Steuereinheit.

Halbleiterbausteine müssen bei verschiedenen Anwendungen auch unter niedrigen Temperaturen von bis zu -40 °C betriebsfähig bleiben. Dies gilt beispielsweise für Halbleiterbausteine der Automobil-Elektronik, der Mobil-Datenübertragungs- und Kommunikationstechnik und allgemein für Halbleiterbausteine, die im Außenbereich installiert sind.

Um dieser Forderung zu genügen, werden bisher in Halbleitervorrichtungen Halbleiterbausteine so ausgestattet, daß diese die genannten tiefen Temperaturen von bis zu -40 °C auszuhalten vermögen und auch unter derart ungünstigen Bedingungen ein befriedigendes Betriebsverhalten zeigen. Mit anderen Worten, bisher werden Arbeitsbereich und Performance von in Halbleitervorrichtungen realisierten Halbleiterbausteinen so weit ausgedehnt, daß sie extrem niedrige Temperaturen auszuhalten vermögen.

Eine andere Möglichkeit zur Gewährleistung eines befriedigenden Betriebsverhaltens auch unter extrem niedrigen Temperaturen besteht darin, für diese niedrigen Temperaturen geeignete Halbleiterbausteine zu selektieren. Ein derartiges Vorgehen ist aber ziemlich aufwendig, da eine Überprüfung aller Halbleiterbausteine auf ihre Tauglichkeit für extrem niedrige Temperaturen zwingend erforderlich ist.

Es wäre nun wünschenswert, wenn Halbleitervorrichtungen bestehen würden, die extrem niedrige Temperaturen auszuhalten vermögen, ohne speziell an einen Betrieb unter diesen niedrigen Temperaturen angepaßt zu sein. Mit anderen Worten, Halbleitervorrichtungen, die mit ihrem Arbeitsbereich und ihrer Performance an Temperaturen bis etwa -10 °C oder -20 °C angepaßt sind, aber dennoch unter extremen Bedingungen auch tiefere Temperaturen bis zu -40 °C aushalten können, wären von großem Vorteil.

Es ist daher Aufgabe der vorliegenden Erfindung, eine Halbleitervorrichtung mit Temperaturregelung zu schaffen, die auch Temperaturen bis zu -40 °C und darunter aushalten kann, ohne mit ihrem Arbeitsbereich und ihrer Performance an solch niedrige Temperaturen speziell angepaßt zu sein.

Diese Aufgabe wird bei einer Halbleitervorrichtung der eingangs genannten Art erfindungsgemäß dadurch gelöst, daß die Steuereinheit bei Unterschreiten eines unteren Grenzwertes durch die von der Temperaturerkennungseinrichtung festgestellte Temperatur die integrierte Schaltung Dummy-Arbeitszyklen ausführen läßt.

Mit anderen Worten, bei der erfindungsgemäßen Halbleitervorrichtung ist vorzugsweise im Halbleiterbaustein eine Temperaturerkennungseinrichtung aus beispielsweise einer Diode vorgesehen, die bei Unterschreiten eines unteren Grenzwertes von beispielsweise 0 °C oder -25 °C die in dem Halbleiterbaustein realisierte integrierte Schaltung veranlaßt, Dummy-Arbeitszyklen, wie beispielsweise zusätzliche Refresh-Zyklen, einen sogenannten Self-Refresh bei einem Halbleiterspeicher, oder auch NOP (Nicht-Operation)-Zyklen, bei denen kein Arbeitsprogramm abläuft, durchzuführen. Durch diese Dummy-Arbeitszyklen wird bei Unterschreiten des unteren Grenzwertes der Temperatur Wärme erzeugt, so daß der Halbleiterbaustein, in den vorzugsweise die integrierte Schaltung, die Temperaturerkennungseinrichtung und die Steuereinheit integriert sind, daran gehindert ist, mit seiner Temperatur unter die untere Grenztemperatur von beispielsweise -25 °C abzufallen. Damit kann der Halbleiterbaustein auch in einer Umgebung von -40 °C oder darunter eingesetzt werden, da seine Temperatur infolge der Dummy-Arbeitszyklen nicht unter ca. -25 °C abfällt.

In einer Weiterbildung der Erfindung ist vorgesehen, daß als zusätzlicher Stromverbraucher ein mit der Steuereinheit verbundener Oszillator vorgesehen ist, der bei Unterschreiten der unteren Grenztemperatur in Betrieb genommen wird, um so zusätzlich Wärme durch seinen Stromverbrauch zu erzeugen. Allerdings wird durch einen solchen, nur zur Wärmeerzeugung dienenden Oszillator zusätzliche Fläche auf dem Chip des Halbleiterbausteines verbraucht.

Wird eine Diode als Temperaturerkennungseinrichtung herangezogen, so kann bei dieser zur Feststellung der Temperatur beispielsweise deren Sperr- oder auch Durchlaßwiderstand gemessen werden. Anstelle einer Diode können aber auch andere geeignete Bauelemente zur Temperaturerkennung herangezogen werden. Wichtig ist lediglich, daß die Temperaturerkennungseinrichtung ein Unterschreiten eines unteren Grenzwertes feststellt, so daß die mit der Temperaturerkennungseinrichtung verbundene Steuereinheit einen Wärmeerzeugungsprozeß durch Dummy-Arbeitszyklen in der integrierten Schaltung und/oder einem gesonderten Oszillator auszulösen vermag.

Bei der erfindungsgemäßen Halbleitervorrichtung ist von wesentlichem Vorteil, daß Performance und Arbeitsbereich einer in einem Halbleiterbaustein realisierten integrierten Schaltung nicht auf den Niedertemperaturbereich von bis zu -40 °C ausgedehnt zu werden brauchen. Dadurch kann der Aufwand für die integrierte Schaltung bzw. den Halbleiterbaustein erheblich vermindert werden. Aufwendige Selektionen von Halbleitervorrichtungen, die für den niedrigen Temperaturbereich von bis zu -40 °C und darunter geeignet sind, können vermieden werden. Ebenso ist ein Testen von Halbleitervorrichtungen bzw. Halbleiterbausteinen auf ihre Tieftemperaturtauglichkeit nicht mehr erforderlich, da diese durch das Abarbeiten der Dummy-Arbeitszyklen ohnehin gegeben ist.

Nachfolgend wird die Erfindung anhand der Zeichnungen näher erläutert. Es zeigen:
- Fig. 1: ein schematisches Schaltbild eines Ausführungsbeispiels der erfindungsgemäßen Halbleitervorrichtung und
- Fig. 2: ein schematisches Diagramm einer Temperaturerkennungseinrichtung in Form einer Diode.

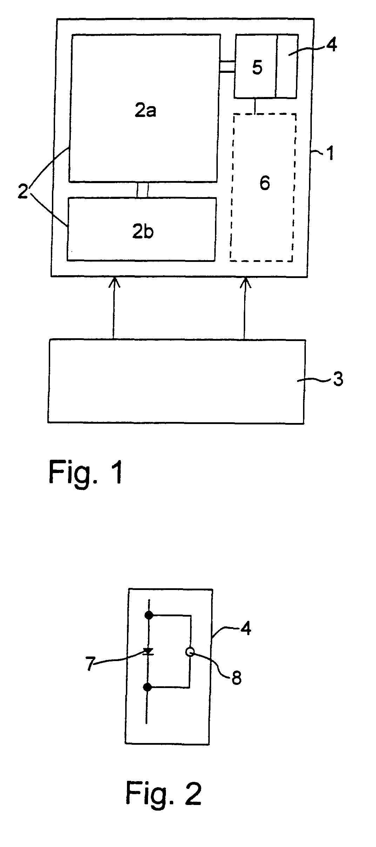

Fig. 1 zeigt einen Halbleiterbaustein 1 mit einer integrierten Schaltung 2 aus beispielsweise einem Speicher 2a und einer Speicherlogik 2b, mit weiterhin einer Temperaturerkennungseinrichtung 4, einer mit der Temperaturerkennungseinrichtung 4 verbundenen Steuereinheit 5 und gegebenenfalls (in Strichlinien gezeigt) einem Oszillator 6. Mit dem Halbleiterbaustein 1 ist eine Strom- bzw. Spannungsversorgung 3 verbunden, die gegebenenfalls aber auch in dem Halbleiterbaustein 1 enthalten sein kann.

Die Temperaturerkennungseinrichtung 4 kann beispielsweise aus einer Diode 7 bestehen, deren Sperr- oder Durchlaßwiderstand mittels einer entsprechenden Meßeinheit 8 gemessen wird. Auf diese Weise kann aus der Kennlinie der Diode 7 auf die Temperatur in der Umgebung der Diode 7 geschlossen werden.

Unterschreitet die von der Temperaturerkennungseinrichtung 4 festgestellte Temperatur einen unteren Grenzwert von beispielsweise -25 °C, so läßt die mit der Temperaturerkennungseinrichtung 4 verbundene Steuereinheit 5 die integrierte Schaltung 2 Dummy-Arbeitszyklen ausführen, wodurch Strom bzw. Spannung von der Strom- bzw. Spannungsversorgung 3 verbraucht und damit Wärme erzeugt wird. Auf diese Weise kann verhindert werden, daß die Temperatur im Bereich des Halbleiterbausteines 1 auf Temperaturen wesentlich unterhalb -25 °C abfällt, obwohl in der Umgebung beispielsweise -40 °C vorliegen.

Der zusätzliche Aufwand für die Temperaturerkennungseinrichtung 4 und die Steuereinheit 5 ist relativ gering im Vergleich zu dem Gewinn, der erzielt wird, da Performance und Arbeitsbereich des Halbleiterbausteines 1 nicht mehr auf Temperaturen bis zu -40 °C ausgelegt zu werden brauchen.

Gegebenenfalls kann zusätzlich ein Oszillator 6 auf dem Halbleiterbaustein 1 vorgesehen werden, welcher bei Unterschreiten des unteren Grenzwertes der Temperatur Wärme erzeugt und so ein Absinken des Halbleiterbausteines auf Temperaturen unterhalb beispielsweise -25 °C verhindert.

## Patentansprüche

1. Halbleitervorrichtung mit wenigstens einer in einem Halbleiterbaustein (1) realisierten integrierten Schaltung (2), einer Strom- bzw. Spannungsversorgung (3), einer Temperaturerkennungseinrichtung (4), die eine Temperatur des Halbleiterbausteines (1) festzustellen vermag, und einer mit der Temperaturerkennungseinrichtung (4) verbundenen Steuereinheit (5),
**dadurch gekennzeichnet,**
**daß** die Steuereinheit (5) bei Unterschreiten eines unteren Grenzwertes durch die von der Temperaturerkennungseinrichtung (4) festgestellte Temperatur die integrierte Schaltung (2) Dummy-Arbeitszyklen ausführen läßt.

2. Halbleitervorrichtung nach Anspruch 1,
**dadurch gekennzeichnet,**
**daß** die integrierte Schaltung (2), die Temperaturerkennungseinrichtung (4) und die Steuereinheit (5) in dem Halbleiterbaustein (1) vorgesehen sind.

3. Halbleitervorrichtung nach Anspruch 1 oder 2,
**dadurch gekennzeichnet,**
**daß** der Halbleiterbaustein (1) zur Wärmeerzeugung einen zusätzlichen Stromverbraucher (6) enthält.

4. Halbleitervorrichtung nach Anspruch 3,
**dadurch gekennzeichnet,**
**daß** der zusätzliche Stromverbraucher (6) ein mit der Steuereinheit (5) verbundener Oszillator ist.

5. Halbleitervorrichtung nach einem der Ansprüche 1 bis 4,
**dadurch gekennzeichnet,**
**daß** die Temperaturerkennungseinrichtung eine Diode (7) aufweist, deren Durchlaßwiderstand gemessen wird.
